(19) Europäisches Patentamt / European Patent Office / Office européen des brevets

(11) **EP 2 721 634 B1**

(12) **FASCICULE DE BREVET EUROPEEN**

(45) Date de publication et mention de la délivrance du brevet:
**03.01.2018 Bulletin 2018/01**

(51) Int Cl.:
**H01L 21/306** (2006.01)   **H01L 21/02** (2006.01)

(21) Numéro de dépôt: **12731132.2**

(86) Numéro de dépôt international:
**PCT/FR2012/051310**

(22) Date de dépôt: **12.06.2012**

(87) Numéro de publication internationale:
**WO 2012/172247 (20.12.2012 Gazette 2012/51)**

(54) **PROCÉDÉ DE PASSIVATION CHIMIQUE D'UNE SURFACE D'UN PRODUIT DE MATÉRIAU SEMI-CONDUCTEUR III-V, ET PRODUIT OBTENU PAR UN TEL PROCÉDÉ**

VERFAHREN ZUR CHEMISCHEN PASSIVIERUNG EINER OBERFLÄCHE EINES PRODUKTS AUS EINEM III-V-HALBLEITER UND ANHAND EINES DERARTIGEN VERFAHRENS GEWONNENES PRODUKT

METHOD FOR CHEMICALLY PASSIVATING A SURFACE OF A PRODUCT MADE OF A III-V SEMICONDUCTOR, AND THE PRODUCT OBTAINED USING SUCH A METHOD

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.06.2011 FR 1155157**

(43) Date de publication de la demande:
**23.04.2014 Bulletin 2014/17**

(73) Titulaires:
- **Centre National de la Recherche Scientifique (C.N.R.S.)**
  **75794 Paris Cedex 16 (FR)**
- **Ecole Polytechnique**
  **91120 Palaiseau (FR)**
- **Université de Versailles Saint-Quentin-en-Yvelines**
  **78035 Versailles Cédex (FR)**

(72) Inventeurs:
- **ETCHEBERRY, Arnaud**
  **F-92700 Colombes (FR)**
- **GONCALVES, Anne-Marie**
  **F-78160 Marly Le Roi (FR)**
- **MATHIEU, Charles**
  **F-78830 Bonnelles (FR)**
- **VIGNERON, Jacky**
  **F-28500 Vernouillet (FR)**
- **MEZAILLES, Nicolas**
  **F-91530 Saint Maurice Montcouronne (FR)**

(74) Mandataire: **Cabinet Plasseraud**
  **66, rue de la Chaussée d'Antin**
  **75440 Paris Cedex 09 (FR)**

(56) Documents cités:
**US-B1- 6 284 317**

- **ANNE-MARIE GONCALVES ET AL: "Fully Protective yet Functionalizable Monolayer on InP", CHEMISTRY OF MATERIALS, vol. 22, no. 10, 25 mai 2010 (2010-05-25), pages 3114-3120, XP055016512, ISSN: 0897-4756, DOI: 10.1021/cm100035a cité dans la demande**
- **OXLAND R K ET AL: "Fluid phase passivation and polymer encapsulation of InP/InGaAs heterojunction bipolar transistors; Passivation and encapsulation of HBTs", SEMICONDUCTOR SCIENCE AND TECHNOLOGY, IOP PUBLISHING LTD, GB, vol. 23, no. 8, 1 août 2008 (2008-08-01), page 85020, XP020142514, ISSN: 0268-1242, DOI: 10.1088/0268-1242/23/8/085020**
- **OSAMU MIKAMI ET AL: "Current-Drift Suppressed InP MISFETs with New Gate Insulator", JAPANESE JOURNAL OF APPLIED PHYSICS,, vol. 23, no. 10, 1 octobre 1984 (1984-10-01), pages 1408-1409, XP001287608,**

## Description

La présente invention est relative aux procédés de passivation chimique d'une surface d'un produit de matériau semi-conducteur III-V, et aux produits obtenus par de tels procédés.

Plus particulièrement, l'invention se rapporte à un procédé de passivation chimique d'une surface d'un produit de matériau semi-conducteur III-V, dans lequel a) on forme un film polymère P,N sur ladite surface par dépôt dans un solvant comprenant de l'ammoniac liquide.

L'article Gonçalves et al., « Fully Protective yet Functionalizable Monolayer on InP », Chemistry of Materials 22 (2010) 3114-3120 décrit un exemple d'un tel procédé, dans lequel on dépose un film polyphosphazène, et qui donne grande satisfaction. En effet, la passivation de la surface obtenue par ce procédé peut être de grande qualité.

Ce film est toutefois formé avec une assistance électrochimique, ce qui présente des inconvénients pratiques empêchant de mettre en oeuvre un tel procédé à l'échelle industrielle. On cherche donc à rendre plus simple la production de tels films.

A cet effet, un procédé du genre en question est caractérisé en ce que ledit film est formé par dépôt sans assistance électrochimique dans ledit solvant, en présence d'un additif chimique à pouvoir oxydant comprenant du phosphore, et générant des porteurs de charge électrique dans ladite surface.

S'agissant de dépôt « sans assistance électrochimique », on peut aussi parler de dépôt « à potentiel de circuit ouvert ».

De manière surprenante, on a constaté que l'adjonction d'un tel additif comprenant du phosphore, dans le solvant permettait de mettre en oeuvre la formation d'un film de type polyphosphazène sans assistance électrochimique. On s'affranchit ainsi des opérations complexes nécessaires aux procédés électrochimiques, comme d'avoir à établir une connectique pour la polarisation. De plus, on obtient un film couvrant et ultra-mince.

Dans des modes de réalisation préférés de l'invention, on peut éventuellement avoir recours en outre à l'une et/ou à l'autre des dispositions suivantes :

- pour l'étape a), on opère par trempage ;
- le matériau « V » est le phosphore ;
- le matériau « III » est l'indium ;
- l'étape a) comprend simultanément une dissolution du matériau semi-conducteur en surface, une oxydation du solvant, et une formation d'un équivalent monomère du polyphosphazène ;
- l'étape a) est mise en oeuvre entre -40°C et -100°C ;
- l'étape a) est mise en oeuvre avec une concentration d'additif comprise entre 0.1 et 3 millimol/l (mM/L) ;
- on met en oeuvre, avant l'étape a), une étape b) de désoxydation d'au moins une partie de ladite surface ;
- l'étape b) est mise en oeuvre pour seulement une partie de la surface ;
- le procédé comprend en outre, après l'étape a), une étape c) de lavage d'une surface passivée à l'étape a) ;
- ledit additif est $PCl_5$.

Selon un autre aspect, l'invention se rapporte à produit comprenant :

- un substrat de matériau semi-conducteur III-V présentant une surface,
- un film de polymère P,N formé sur ladite surface,

caractérisé en ce que ledit film présente, en spectrométrie photoélectronique XPS, pour $N_{1S}$, un spectre présentant un premier pic pour une forte énergie de liaison et un deuxième pic pour une faible énergie de liaison, le premier pic étant d'amplitude au moins 20% supérieure au deuxième pic.

D'autres caractéristiques et avantages de l'invention apparaîtront au cours de la description suivante d'une de ses formes de réalisation, donnée à titre d'exemple non limitatif, en regard des dessins joints.

Sur les dessins :

- la figure 1 est une vue schématique d'une installation pour la mise en oeuvre d'un procédé selon un exemple de réalisation,
- la figure 2a est une vue schématique en coupe d'un produit selon un premier mode de réalisation avant application du procédé,
- la figure 2b est une vue correspondant à la figure 2a après application du procédé,
- les figures 3a et 3b sont des vues correspondant respectivement aux figures 2a et 2b pour un produit selon un deuxième mode de réalisation,
- la figure 4 est une courbe représentative de spectrométrie photoélectronique XPS pour $N_{1S}$ pour un produit obtenu par le procédé ci-dessus, et

- la figure 4a est une courbe similaire à la courbe représentée sur la figure 4 pour des produits obtenus par des procédés avec assistance électrochimique.

Sur les différentes figures, les mêmes références désignent des éléments identiques ou similaires.

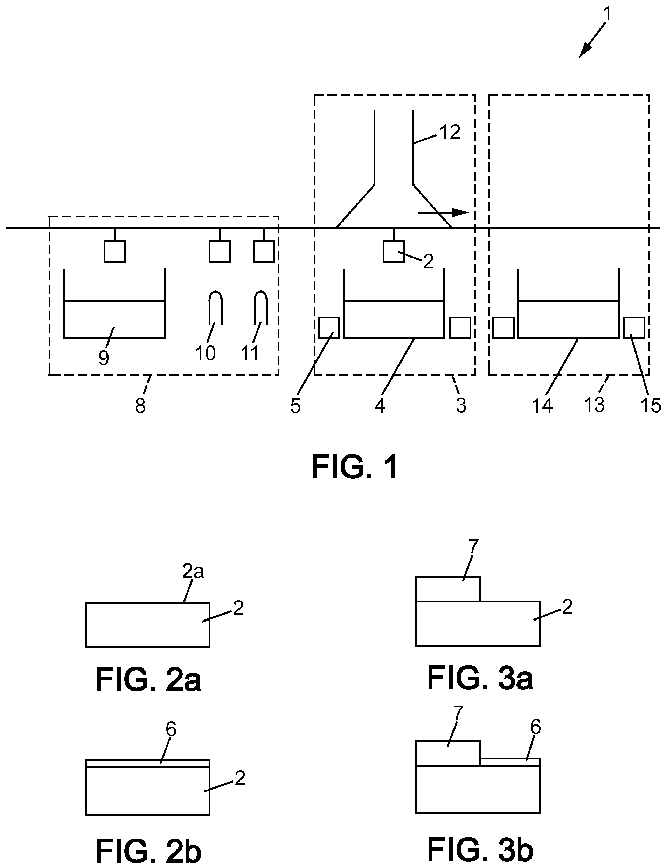

La figure 1 est une vue schématique représentant une installation 1 de passivation de la surface d'un produit de matériau semi-conducteur III-V. Un exemple de produit est représenté sur la figure 2a. Le produit 2 est formé d'un matériau semi-conducteur III-V. Il est fabriqué à partir d'un ou plusieurs éléments de la colonne « III » du tableau périodique des éléments (notamment l'Indium) et d'un ou plusieurs éléments de la colonne « V »du tableau périodique des éléments (notamment antimoine ou phosphore). A titre d'exemple, le matériau considéré est le phosphure d'indium InP. Le produit 2 comprend une surface 2a qu'on cherche à passiver.

Comme cela est représenté à la figure 1, l'installation 21 comprend un appareil de passivation 3. Celui-ci comprend un récipient 4 contenant un solvant liquide. A titre d'exemple, le solvant en question est constitué d'ammoniac liquide $NH_3$. L'appareil 3 comprend également des moyens de régulation de température 5, tel qu'un cryostat, adapté pour maintenir l'ammoniac en état liquide.

Le produit 2 est placé dans le solvant en présence d'un additif. Cet additif présente un pouvoir oxydant du matériau semi-conducteur III-V dans ledit solvant. On utilise, en particulier, un oxydant :

- qui comprenne du phosphore,
- qui soit compatible avec le solvant ammoniac liquide,
- qui puisse générer des porteurs de charge électrique (trous) dans la surface 2a du produit 2.

Un exemple particulier d'un tel additif est le pentachlorure de phosphore ($PCl_5$).

A titre d'exemple, on utilise comme solvant de l'ammoniac liquide obtenu par une simple détente dans une cellule ouverte de liquéfaction en verre maintenue à une température de -78°C grâce à un bain réfrigérant (par exemple de l'acétone chargé en carboglace) confiné dans un vase Dewar. Dans l'alternative, on pourrait également travailler dans un cryostat thermostaté entre -40°C et - 100°C, de préférence entre -50°C et -70°C ou dans tout autre type d'enceinte réfrigérante assurant un maintien à température constante dans la gamme ci-dessus. L'ammoniac liquide peut être pris sous forme neutre, c'est-à-dire en totale pureté, ou acide (en introduisant par exemple $NH_4Cl$ ou Br à 0,1 mole/litre de solvant).

A titre d'additif à pouvoir d'oxydant du matériau semi-conducteur III-V, on utilise $PCl_5$. Ce dernier est introduit après pesée, et mis en solution de façon standard à hauteur de 1 à 3 millimoles/litre de solvant. Le cas échéant, on peut utiliser des concentrations inférieures de PCl5, par exemple de l'ordre de 0,1 à 1 millimole par litre. Les conditions sont réunies pour le dépôt sans assistance électrochimique d'un film 6 polymère P,N de type polyphosphazène à la surface 2a du produit 2 (cf. Fig. 2b).

De manière générale, le polyphosphazène est un polymère du type $(-RR'P=N-)_n$, où les substituants R,R' sont généralement des alcoxy, des amino, des $R_2N$ ou des halogènes.

Dans le cas présent, on propose que le mécanisme (dans sa version électrochimique) à la base de la réaction puisse s'écrire, dans le cas du phosphure d'indium :

$$InP + 9NH_3 + 9h^+ \rightarrow (H_2N\text{-}P=NH) + 6NH_4^+ + In^{3+} + 1/2N_2$$

Cette équation englobe trois phénomènes du mécanisme conduisant à la passivation :

- une dissolution du matériau à l'échelle nanométrique,
- une oxydation du solvant, et
- l'obtention d'un équivalent monomère.

L'ensemble génère le pavage continu de la surface 2a, qui crée le phénomène d'auto-régulation grâce au facteur limitant de la couverture. Cette auto-régulation maintient, en terme de rugosité, un état final très proche de l'état initial, ce qui exclut des perturbations morphologiques parasites indésirables dans une configuration optique.

$PCl_5$ permet d'injecter des porteurs de charge récupérables dans la surface, pour engager un mécanisme de production d'un film polymère P,N de type polyphosphazène similaire au mécanisme décrit ci-dessus en version électrochimique. De plus, ce composant est compatible avec l'ammoniac liquide.

Le procédé est complètement mis en oeuvre sans assistance électrochimique (ou « electroless »), permettant ainsi de créer un film de surface sans mettre en oeuvre des étapes complexes de reprise de contact obligatoires pour des procédés à assistance électrochimique connus.

Le procédé décrit ci-dessus est de plus compatible avec les procédés de masquage typique utilisés pour des composants de ce type. Comme décrit par exemple sur la figure 3a, le produit 2 porte en surface un masque 7, par exemple de type Si$_3$N$_4$, SiO$_2$, ZnS, ou polymère compatible avec l'ammoniac liquide. Dans ce cas, comme représenté sur la figure 3b, le film 6 de passivation est formé uniquement sur une partie de surface du produit. En variante, le masque 7 pourrait être formé d'un oxyde du matériau III-V du produit 2. En effet, les oxydes, en particulier de InP ou de GaP, sont parfaitement stables dans l'ammoniac liquide, même en présence de PCl$_5$.

A titre d'exemple, si on ne souhaite pas qu'un tel oxyde gêne la formation du film 6 de passivation, l'installation 1 peut également comprendre une unité de désoxydation 8 en amont de l'appareil de passivation 3 proprement dit. Ainsi, l'échantillon 2 est d'abord soumis au procédé de désoxydation, avant d'être soumis à la formation du film de type polyphosphazène. A titre d'exemple de procédé de désoxydation, on peut par exemple prévoir de tremper l'échantillon dans une solution désoxydante 9, typiquement HCl 1M/eau ultra pure pendant quelques minutes, puis un rinçage 10 à l'eau ultra pure et un séchage 11, par exemple sous jet d'argon ou d'azote.

Dans cet exemple de réalisation, l'échantillon ainsi conditionné est immédiatement chargé dans la solution d'ammoniac liquide pour y être passivé.

Le procédé est ainsi particulièrement compatible avec les autres étapes industrielles de la fabrication de composants semi-conducteurs III-V.

Après l'étape de formation du film de passivation, on peut également avoir recours à une étape d'extraction. Par exemple, la nacelle de suspension de l'échantillon est retirée brusquement du bain 4 de traitement, simplement sous hotte d'aspiration 12. On peut ensuite procéder à une étape de lavage 13, par exemple en plongeant l'échantillon dans un bain 14 d'ammoniac ultra pur. Cette étape peut durer, voire servir pour un stockage intermédiaire avant extraction définitive. L'extraction définitive se fait par exemple par remontée progressive en température de l'échantillon maintenu dans sa nacelle par l'intermédiaire d'un dispositif de régulation de température 15. L'échantillon traité est ensuite stocké dans un support classique pour plaque semi-conductrice.

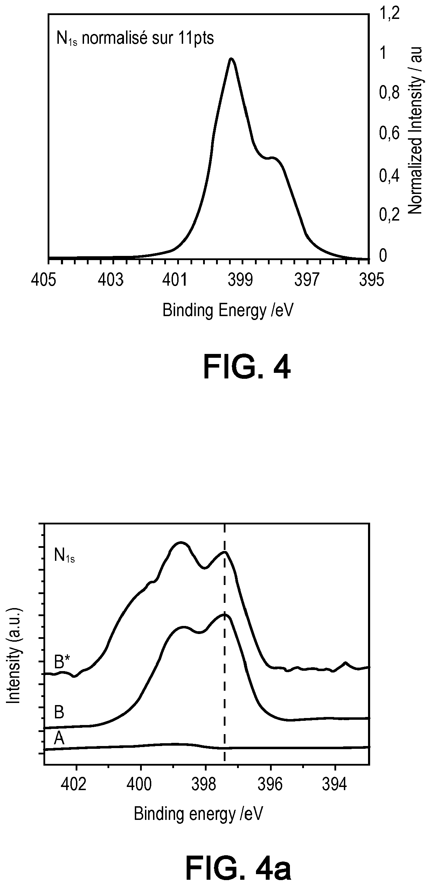

Il a par ailleurs été observé que le film de polymère P,N obtenu sans assistance électrochimique par le procédé décrit ci-dessus, est différent du film polyphosphazène obtenu par les procédés à assistance électrochimiques de l'art antérieur. On peut parler d'un film « de type polyphosphazène », dans la mesure où il présente des caractéristiques proches de films polyphosphazène, sans toutefois être identique. En particulier, la mesure de spectrométrie photoélectronique XPS associée à N$_{1S}$ présente des différences notables, telles que représentées sur la figure 4, pour le procédé sans assistance électrochimique décrit ci-dessus, et sur la figure 4a pour le procédé électrochimique antérieur. Sur la figure 4a, relative à la réponse N$_{1\Delta}$ d'échantillons InP, la courbe A correspond à une surface InP tout juste désoxydée, la courbe B est obtenue après un traitement anodique par assistance électrochimique dans l'ammoniac liquide et un stockage dans l'air pendant au moins un an, et la courbe B* est obtenue en rajoutant une étape d'immersion pendant 16 heures dans une solution désoxygénée aqueuse de K$_2$PtCl$_4$ (3 millimoles/litre) après les deux étapes du procédé correspondant à la courbe B (cette étape induit une réaction des groupes amines de la surface passivée vis-à-vis de PtCl$_4^{2-}$ et agit comme révélateur (cf. la publication mentionnée ci-dessous)). Comme on peut le voir en particulier sur la figure 4, en intensité normalisée en unités arbitraires, le spectre présente un premier pic pour une énergie de liaison environ égale à 399 électrons volt, et un deuxième pic pour une énergie de liaison environ égale à 398 électrons volt. L'amplitude du premier pic (énergie de liaison la plus élevée) est nettement supérieure à celle du deuxième pic (au moins 20% supérieure), et ce de manière très reproductible. Ce spectre caractérise bien le film obtenu par le procédé décrit ci-dessus et suggère un grand ordre de surface pour un des environnements chimiques de l'azote dans le film. Par pic, on entend que la courbe d'intensité en fonction de l'énergie présente un maximum entre une partie croissante et une partie décroissante. A titre de comparaison, on notera que, pour les procédés électrolytiques de la figure 4a, le spectre présente deux pics principaux d'amplitudes semblables.

Par ailleurs, le film formé est très mince et ceci est démontré par l'ensemble des données XPS.

On peut donc considérer une telle mesure de spectre XPS comme une signature de la mise en oeuvre anélectrolytique du procédé de formation du film de type polyphosphazène.

La présente description a été donnée principalement en référence au phosphure d'Indium (InP). Il est présumé que les principes à la base de l'invention s'appliquent également aux autres matériaux III-P, toute précaution nécessaire à l'utilisation d'un autre matériau III-P étant prise par ailleurs. En particulier, on présume que la mise en oeuvre du procédé ci-dessus à un matériau de type phosphure de gallium (GaP) est possible.

**Revendications**

1. Procédé de passivation chimique d'une surface d'un produit de matériau semi-conducteur III-V, dans lequel a) on forme un film (6) polymère phosphore (P), azote (N) sur ladite surface (2a) par dépôt dans un solvant comprenant de l'ammoniac liquide,
**caractérisé en ce que** ledit film est formé par dépôt sans assistance électrochimique dans ledit solvant, en présence d'un additif à pouvoir oxydant comprenant du phosphore, et générant des porteurs de charge électrique dans ladite surface.

2. Procédé selon la revendication 1, dans lequel pour l'étape a), on opère par trempage.

3. Procédé selon l'une des revendications 1 à 2, dans lequel le matériau « V » est le phosphore.

4. Procédé selon l'une des revendications 1 à 3, dans lequel le matériau « III » est l'indium.

5. Procédé selon l'une des revendications 1 à 4, dans lequel l'étape a) comprend simultanément une dissolution du matériau semi-conducteur en surface, une oxydation du solvant, et une formation d'un équivalent monomère du polyphosphazène.

6. Procédé selon l'une des revendications 1 à 5, dans lequel l'étape a) est mise en oeuvre entre -40°C et -100°C.

7. Procédé selon l'une des revendications 1 à 6, dans lequel l'étape a) est mise en oeuvre avec une concentration d'additif comprise entre 0.1 et 3 millimol/l (mM/L).

8. Procédé selon l'une des revendications 1 à 7, dans lequel on met en oeuvre, avant l'étape a), une étape b) de désoxydation d'au moins une partie de ladite surface.

9. Procédé selon la revendication 8, dans lequel l'étape b) est mise en oeuvre pour seulement une partie de la surface.

10. Procédé selon l'une des revendications 1 à 9, comprenant en outre, après l'étape a), une étape c) de lavage d'une surface passivée à l'étape a).

11. Procédé selon l'une des revendications 1 à 10, dans lequel ledit additif est $PCl_5$.

12. Produit comprenant :

- un substrat (12) de matériau semi-conducteur III-V présentant une surface,
- un film (6) de polymère phosphore (P), azote (N) formé sur ladite surface,

**caractérisé en ce que** ledit film présente, en spectrométrie photoélectronique XPS, pour $N_{1S}$, un spectre présentant un premier pic pour une forte énergie de liaison, et un deuxième pic pour une faible énergie de liaison, le premier pic étant d'amplitude au moins 20% supérieure au deuxième pic.

**Patentansprüche**

1. Verfahren zum chemischen Passivieren einer Oberfläche eines Produkts aus einem III-V-Halbleiter-Material, bei welchem

a) durch Ablagerung in einem Lösungsmittel, welches flüssigen Ammoniak enthält, ein Polymer-Phosphor-(P) Stickstoff (N) Film (6) auf dieser Oberfläche (2a) gebildet wird,

**dadurch gekennzeichnet, dass** der Film in dem Lösungsmittel durch Ablagerung ohne elektrochemische Unterstützung gebildet wird, in Anwesenheit eines Zusatzes mit Oxidationskraft, der Phosphor umfasst und in der Oberfläche elektrische Ladungsträger generiert.

2. Verfahren nach Anspruch 1, bei welchem in Schritt a) durch Eintauchen vorgegangen wird.

3. Verfahren nach einem der Ansprüche 1 bis 2, bei welchem das Material "V" der Phosphor ist.

4. Verfahren nach einem der Ansprüche 1 bis 3, bei welchem das Material "III" das Indium ist.

5. Verfahren nach einem der Ansprüche 1 bis 4, bei welchem der Schritt a) gleichzeitig eine Auflösung des Halbleitermaterials an der Oberfläche, eine Oxidation des Lösungsmittels und eine Bildung eines Polyphosphazen-Monomer-Äquivalents umfasst.

6. Verfahren nach einem der Ansprüche 1 bis 5, bei welchem der Schritt a) zwischen - 40°C und - 100°C durchgeführt wird.

7. Verfahren nach einem der Ansprüche 1 bis 6, bei welchem der Schritt a) mit einer Konzentration des Zusatzstoffes zwischen 0,1 und 3 Millimol/l (mM/L) durchgeführt wird.

8. Verfahren nach einem der Ansprüche 1 bis 7, bei welchem vor dem Schritt a) ein Schritt b) der Desoxidation zumindest eines Teils der Oberfläche durchgeführt wird.

9. Verfahren nach Anspruch 8, bei welchem der Schritt b) nur für einen Teil der Oberfläche durchgeführt wird.

10. Verfahren nach einem der Ansprüche 1 bis 9, welches ferner nach dem Schritt a) einen Schritt c) des Waschens einer in Schritt a) passivierten Oberfläche umfasst.

11. Verfahren nach einem der Ansprüche 1 bis 10, bei welchem der Zusatz PC15 ist.

12. Produkt, umfassend:

   - ein Substrat (12) aus III-V-Halbleitermaterial, welches eine Oberfläche aufweist,
   - einen auf der Oberfläche gebildeten Polymer-Phosphor-(P) Stickstoff (N) Film (6),

   **dadurch gekennzeichnet, dass** der Film in der XPS Photoelektronenspektrometrie für $N_{1S}$ ein Spektrum aufweist, welches eine erste Spitze für eine starke Bindungsenergie aufweist und eine zweite Spitze für eine schwache Bindungsenergie aufweist, wobei die erste Spitze eine wenigstens 20% größere Amplitude aufweist als die zweite Spitze.

**Claims**

1. Method for chemically passivating a surface of a product made of a III-V semiconductor material in which a) a phosphorus (P),(nitrogen) N polymer film (6) is formed on said surface (2a) by deposition in a solvent comprising liquid ammonia,
   **characterized in that** said film is formed by deposition, without electrochemical assistance, in said solvent, in the presence of an oxidizing chemical additive comprising phosphorous and generating electrical charge carriers in said surface.

2. Method according to claim 1, in which, for step a), we make use of dipping.

3. Method according to one of claims 1 to 2, in which the "V" material is phosphorous.

4. Method according to one of claims 1 to 3, in which the "III" material is indium.

5. Method according to one of claims 1 to 4, in which step a) simultaneously comprises dissolution of the surface semiconductor material, oxidation of the solvent, and formation of a monomer equivalent of polyphosphazene.

6. Method according to one of claims 1 to 5, in which step a) is implemented between -40 °C and -100 °C.

7. Method according to one of claims 1 to 6, in which step a) is implemented with an additive concentration comprised between 0.1 and 3 millimoles per liter (mM/L).

8. Method according to one of claims 1 to 7, in which we implement, before step a), a step b) involving deoxidation of at least one portion of said surface.

9. Method according to claim 8, in which step b) is implemented only for a portion of the surface.

10. method according to any of claims 1 to 9, also comprising, after step a), a step c) involving washing of a surface passivated in step a).

11. Method according to one of claims 1 to 10, in which said additive is $PCl_5$.

12. Product comprising:

> - a substrate (12) of III-V semiconductor material presenting a surface,
> - a phosphorus (P),(nitrogen) N polymer film (6) formed on said surface,

**characterized in that** said film presents, during x-ray photoelectron spectrometry (XPS), for $N_{1S}$, a spectrum having a first peak with a high binding energy and a second peak with a low binding energy, the first peak having an amplitude at least 20% greater than the second peak.

FIG. 1

FIG. 2a

FIG. 3a

FIG. 2b

FIG. 3b

FIG. 4

FIG. 4a

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **GONÇALVES et al.** Fully Protective yet Functionalizable Monolayer on InP. *Chemistry of Materials,* 2010, vol. 22, 3114-3120